# EUROPÄISCHE PATENTANMELDUNG

(11) **EP 4 032 870 A1**
(43) Veröffentlichungstag der Anmeldung: **27.07.2022**
(21) Anmeldenummer: 21152896.3
(22) Anmeldetag: 22.01.2021
(51) Int. Cl.: C04B 37/02, C23F 1/02, H05K 3/06

(54) **VERFAHREN ZUR STRUKTURIERUNG VON METALL-KERAMIK-SUBSTRATEN UND STRUKTURIERTES METALL-KERAMIK-SUBSTRAT**

(71) Anmelder: Heraeus Deutschland GmbH & Co. KG, 63450 Hanau (DE)
(72) Erfinder: Wacker, Richard, 63450 Hanau (DE); Schnee, Daniel, 63450 Hanau (DE); Schwoebel, Andre, 63450 Hanau (DE); Scharf, Juergen, 63450 Hanau (DE)
(74) Vertreter: Heraeus IP

(57) **Zusammenfassung**

Die Erfindung betrifft ein Verfahren zur Strukturierung von Metall-Keramik-Substraten sowie ein strukturiertes Metall-Keramik-Substrat, das insbesondere in der Leistungselektronik zum Einsatz kommen kann. Bei dem Verfahren werden ein erstes Metall-Keramik-Substrat und ein zweites Metall-Keramik-Substrat geätzt, wobei bei der Kontaktierung mit einer Ätzlösung, die in der Lage ist, Aktivmetall aus der Verbindungsschicht der Metall-Keramik-Substrate abzutragen, das erste Metall-Keramik-Substrat und das zweite Metall-Keramik-Substrat so angeordnet sind, dass eine Orthogonalprojektion des ersten Metall-Keramik-Substrats auf eine Projektionsebene parallel zur Metallschicht des ersten Metall-Keramik-Substrats die Metallschicht des zweiten Metall-Keramik-Substrats zu nicht mehr als 60% abschattet.

## Beschreibung

Die vorliegende Erfindung betrifft ein Verfahren zur Strukturierung von Metall-Keramik-Substraten sowie ein strukturiertes Metall-Keramik-Substrat.

Metall-Keramik-Substrate spielen eine wichtige Rolle im Bereich der Leistungselektronik. Sie sind ein maßgebliches Element beim Aufbau von elektronischen Bauteilen und sorgen für eine schnelle Ableitung hoher Wärmemengen beim Betrieb dieser Bauteile. Metall-Keramik-Substrate bestehen üblicherweise aus einer Keramikschicht und einer Metallschicht, die mit der Keramikschicht verbunden ist.

Zur Verbindung der Metallschicht mit der Keramikschicht sind aus dem Stand der Technik mehrere Verfahren bekannt. Beim sogenannten DCB ("Direct Copper Bonding") -Verfahren wird eine Kupferfolie durch Reaktion von Kupfer mit einem Reaktivgas (üblicherweise Sauerstoff) oberflächlich mit einer Kupferverbindung (üblicherweise Kupferoxid) versehen, die einen niedrigeren Schmelzpunkt als Kupfer aufweist. Wenn die so behandelte Kupferfolie auf einen Keramikkörper aufgebracht und der Verbund gebrannt wird, schmilzt die Kupferverbindung und benetzt die Oberfläche des Keramikkörpers, so dass es zu einer stabilen stoffschlüssigen Verbindung zwischen der Kupferfolie und dem Keramikkörper kommt. Dieses Verfahren ist zum Beispiel in der US 3744120 A oder der DE 2319854 C2 beschrieben.

Trotz offensichtlicher Vorteile weist das DCB-Verfahren zwei Hauptnachteile auf. Erstens muss das Verfahren bei relativ hohen Temperaturen durchgeführt werden, nämlich etwas unterhalb des Schmelzpunktes von Kupfer. Zweitens kann das Verfahren nur für Keramiken auf Aluminiumbasis wie Aluminiumoxid oder Aluminiumnitrid verwendet werden. Daher besteht ein Bedarf an einem alternativen Verfahren zur Herstellung von Metall-Keramik-Substraten unter weniger strengen Bedingungen. In einem alternativen Verfahren können Metallfolien bei Temperaturen von etwa 650 bis 1000°C mit Keramikkörpern verbunden werden, wobei ein spezielles Lot verwendet wird, das üblicherweise Silber und/oder Kupfer und ein Aktivmetall enthält. Die Rolle des Aktivmetalls besteht darin, mit dem Keramikmaterial zu reagieren und so eine Verbindung des Keramikmaterials mit dem übrigen Lot unter Bildung einer Reaktionsschicht zu ermöglichen, während das Kupfer und/oder Silber zur Verbindung dieser Reaktionsschicht mit der Metallfolie dient. So schlägt zum Beispiel die JP4812985 B2 vor, eine Kupferfolie mit einem Keramikkörper unter Verwendung eines Lotes zu verbinden, das 50 bis 89 Gewichtsprozent Silber sowie darüber hinaus Kupfer, Bismut und ein Aktivmetall enthält. Mit diesem Verfahren gelingt es, die Kupferfolie mit dem Keramikkörper zuverlässig zu fügen. Um Probleme im Zusammenhang mit der Migration von Silber zu vermeiden, kann es vorteilhaft sein, silberfreie Lote zur Verbindung von Metallfolien mit Keramikkörpern zu verwenden. Eine solche Technik wird zum Beispiel in der DE 102017114893 A1 vorgeschlagen. Die derart hergestellten Metall-Keramik-Substrate weisen daher neben einer Metallschicht und einer Keramikschicht eine zwischen der Metallschicht und der Keramikschicht liegende Verbindungsschicht auf, die ein Aktivmetall enthält.

Nach der Verbindung der Metallfolie mit dem Keramikkörper wird das entstandene Metall-Keramik-Substrat üblicherweise zum Aufbau von Leiterbahnen strukturiert. Hierzu werden in der Regel herkömmliche Ätztechniken eingesetzt. Gemäß einem gängigen Verfahren wird die Metalloberfläche des Metall-Keramik-Substrats mit einer Maskierung, zum Beispiel mit einem Polymer, versehen. Durch diese Maskierung werden diejenigen Stellen des Metall-Keramik-Substrats, die im folgenden Ätzschritt nicht entfernt werden sollen, geschützt, währen die unmaskierten Stellen für eine Ätzung zugänglich sind. Bei der Ätzung werden dann durch Verwendung mehrerer Ätzlösungen das Metall der Metallfolie und die Bestandteile der Verbindungsschicht in Lösung gebracht und vom Metall-Keramik-Substrat entfernt, wodurch Leiterbahnen entstehen. Anschließend wird die Maskierung entfernt, wodurch ein strukturiertes Metall-Keramik-Substrat enthalten wird.

Gemäß einem herkömmlichen Verfahren werden bei der Behandlung mit einer ersten Ätzlösung das Metall der Metallfolie sowie Bestandteile des Lots der Verbindungsschicht entfernt, wobei wenigstens das Aktivmetall übrig bleibt. Das Aktivmetall wird anschließend durch Behandlung mit einer zweiten Ätzlösung in Lösung gebracht und entfernt. Um einen möglichst hohen Durchsatz zu erreichen, werden die Metall-Keramik-Substrate üblicherweise in einer Haltevorrichtung gestapelt und in der Haltevorrichtung mit den Ätzlösungen kontaktiert. Dabei hat sich das vertikale Stapeln der Metall-Keramik-Substrate aus Praktikabilitätsgründen als besonders vorteilhaft erwiesen. Um eine vollständige Ätzung zu gewährleisten, müssen die Metall-Keramik-Substrate längere Zeit mit den Ätzlösungen kontaktiert werden.

Grundsätzlich besteht der Bedarf, die Verweilzeit der Metall-Keramik-Substrate in den Ätzlösungen zu reduzieren. Damit ließe sich das Verfahren zur Strukturierung von Metall-Keramik-Substraten schneller, effizienter, ressourcenschonender und energieschonender durchführen. Ferner besteht der Bedarf, innerhalb einer vorgegebenen Zeit einen möglichst vollständigen Abtrag des beim Ätzen zu entfernenden Materials, insbesondere des Aktivmetalls, zu erreichen.

Die vorliegende Erfindung stellt sich daher die Aufgabe, ein einfaches Verfahren zur Strukturierung von Metall-Keramik-Substraten bereitzustellen. Vorzugsweise soll dieses Verfahren schneller, effizienter, ressourcenschonender und/oder energieschonender sein als die aus dem Stand der Technik bekannten Verfahren. Ferner ist es bevorzugt, dass das Verfahren in einer vorgegebenen Zeit zu einem möglichst vollständigen Abtrag des beim Ätzen zu entfernenden Materials, insbesondere des Aktivmetalls, führt.

Diese Aufgabe wird gelöst durch das Verfahren von Anspruch 1.

Die Erfindung stellt daher ein Verfahren zur Strukturierung von Metall-Keramik-Substraten bereit, umfassend die Schritte:
a) Bereitstellung eines ersten Metall-Keramik-Substrats und eines zweiten Metall-Keramik-Substrats, jeweils aufweisend
   - eine Keramikschicht,
   - eine Metallschicht und
   - eine Verbindungsschicht, die sich zwischen der Keramikschicht und der Metallschicht befindet, wobei die Verbindungsschicht (i) ein Metall mit einem Schmelzpunkt von wenigstens 700°C und (ii) ein Aktivmetall aufweist,
b) Bereitstellung einer Ätzlösung 1, die in der Lage ist, das Metall aus der Metallschicht und wenigstens teilweise das Metall mit einem Schmelzpunkt von wenigstens 700°C aus der Verbindungsschicht abzutragen,
c) Bereitstellung einer Ätzlösung 2, die in der Lage ist, das Aktivmetall aus der Verbindungsschicht abzutragen,
d) Maskierung von Bereichen auf der Metallschicht des ersten Metall-Keramik-Substrats und auf der Metallschicht des zweiten Metall-Keramik-Substrats, die nicht für das Abtragen vorgesehen sind,
e) Kontaktierung des ersten Metall-Keramik-Substrats und des zweiten Metall-Keramik-Substrats mit der Ätzlösung 1 und
f) Kontaktierung des ersten Metall-Keramik-Substrats und des zweiten Metall-Keramik-Substrats mit der Ätzlösung 2, wobei das erste Metall-Keramik-Substrat und das zweite Metall-Keramik-Substrat so angeordnet sind, dass eine Orthogonalprojektion des ersten Metall-Keramik-Substrats auf eine Projektionsebene parallel zur Metallschicht des ersten Metall-Keramik-Substrats die Metallschicht des zweiten Metall-Keramik-Substrats zu nicht mehr als 60% abschattet.

Ferner stellt die Erfindung ein Metall-Keramik-Substrat bereit, das durch dieses Verfahren erhältlich ist.

Das erfindungsgemäße Verfahren betrifft die Strukturierung von Metall-Keramik-Substraten.

Dazu werden zunächst ein erstes Metall-Keramik-Substrat und ein zweites Metall-Keramik-Substrat bereitgestellt.

Das erste und das zweite Metall-Keramik-Substrat weisen jeweils eine Metallschicht auf. Das Metall der Metallschicht ist vorzugsweise aus der Gruppe ausgewählt, die aus Kupfer, Aluminium und Molybdän besteht. Gemäß einer besonders bevorzugten Ausführungsform ist das Metall der Metallschicht aus der Gruppe ausgewählt, die aus Kupfer und Molybdän besteht. Gemäß einer ganz besonders bevorzugten Ausführungsform ist das Metall der Metallschicht Kupfer. Die Metallschicht weist vorzugsweise eine Dicke im Bereich von 0,01 - 10 mm, mehr bevorzugt im Bereich von 0,03 - 5 mm und besonders bevorzugt im Bereich von 0,05 - 3 mm auf.

Das erste und das zweite Metall-Keramik-Substrat weisen jeweils eine Keramikschicht auf. Die Keramik der Keramikschicht ist vorzugsweise eine isolierende Keramik. Bei der Keramik kann es sich beispielsweise um eine Oxidkeramik, eine Nitridkeramik oder eine Carbidkeramik handeln. Vorzugsweise handelt es sich bei der Keramik um eine Metalloxidkeramik, eine Siliziumoxidkeramik, eine Metallnitridkeramik, eine Siliziumnitridkeramik, eine Bornitridkeramik oder eine Borcarbidkeramik. Gemäß einer bevorzugten Ausführungsform ist die Keramik aus der Gruppe ausgewählt, die aus Aluminiumnitridkeramiken, Siluziumnitridkeramiken und Aluminiumoxidkeramiken (wie zum Beispiel ZTA ("Zirconia Toughened Alumina") -Keramiken) besteht. Die Keramikschicht weist vorzugsweise eine Dicke von 0,05 - 10 mm, mehr bevorzugt im Bereich von 0,1 - 5 mm und noch mehr bevorzugt im Bereich von 0,15 - 3 mm auf.

Das erste Metall-Keramik-Substrat und das zweite Metall-Keramik-Substrat weisen jeweils eine Verbindungsschicht auf, die sich zwischen der Keramikschicht und der Metallschicht befindet. Die Verbindungsschicht stellt vorzugsweise eine stoffschlüssige Verbindung zwischen der Keramikschicht und der Metallschicht her.

Die Verbindungsschicht weist (i) ein Metall mit einem Schmelzpunkt von wenigstens 700°C und (ii) ein Aktivmetall auf. Das Metall mit einem Schmelzpunkt von wenigstens 700°C weist vorzugsweise einen Schmelzpunkt von wenigstens 850°C und mehr bevorzugt einen Schmelzpunkt von wenigstens 1000°C auf. Gemäß einer bevorzugten Ausführungsform ist das Metall mit einem Schmelzpunkt von wenigstens 700°C aus der Gruppe ausgewählt, die aus Kupfer, Silber, Nickel, Wolfram, Molybdän und Mischungen davon besteht. Gemäß einer besonders bevorzugten Ausführungsform ist das Metall mit einem Schmelzpunkt von wenigstens 700°C aus der Gruppe ausgewählt, die aus Kupfer, Nickel, Wolfram, Molybdän und Mischungen davon besteht. Gemäß einer ganz besonders bevorzugten Ausführungsform ist das Metall mit einem Schmelzpunkt von wenigstens 700°C Kupfer. Der Gehalt an dem wenigstens einen Metall mit einem Schmelzpunkt von wenigstens 700°C beträgt vorzugsweise 55 - 93 Atomprozent, besonders bevorzugt 60 - 85 Atomprozent und ganz besonders bevorzugt 65 - 80 Atomprozent, bezogen auf die Anzahl an Atomen in der Verbindungsschicht.

Das Aktivmetall ist vorzugweise aus der Gruppe ausgewählt, die aus Titan, Zirkonium, Niob, Tantal, Vanadium, Hafnium und Mischungen davon besteht. Gemäß einer besonders bevorzugten Ausführungsform ist das Aktivmetall Titan. Der Gehalt an dem Aktivmetall beträgt vorzugsweise 1 - 10 Atomprozent, besonders bevorzugt 2 - 8 Atomprozent und ganz besonders bevorzugt 3 - 7 Atomprozent, bezogen auf die Anzahl an Atomen in der Verbindungsschicht.

Die Verbindungsschicht kann gemäß einer bevorzugten Ausführungsform neben (i) einem Metall mit einem Schmelzpunkt von wenigstens 700°C und ii) einem Aktivmetall zusätzlich (iii) weitere Elemente als Rest aufweisen. Gemäß einer besonders bevorzugten Ausführungsform beträgt der Gehalt an weiteren Elementen in der Verbindungsschicht 5 - 40 Atomprozent, mehr bevorzugt 7 - 35 Atomprozent und besonders bevorzugt 10 - 35 Atomprozent, bezogen auf die Anzahl an Atomen in der Verbindungsschicht.

So weist die Verbindungsschicht gemäß einer weiteren bevorzugten Ausführungsform ein Metall mit einem Schmelzpunkt von weniger als 700°C auf. Das Metall mit einem Schmelzpunkt von weniger als 700°C weist vorzugsweise einen Schmelzpunkt von weniger als 600°C und besonders bevorzugt einen Schmelzpunkt von weniger als 550°C auf. Gemäß einer bevorzugten Ausführungsform ist das Metall mit einem Schmelzpunkt von weniger als 700°C aus der Gruppe ausgewählt, die aus Zinn, Bismut, Indium, Gallium, Zink, Antimon, Magnesium und Mischungen davon besteht. Gemäß einer besonders bevorzugten Ausführungsform ist das Metall mit einem Schmelzpunkt von weniger als 700°C aus der Gruppe ausgewählt, die aus Zinn, Bismut und Mischungen davon besteht. Der Gehalt an dem wenigstens einen Metall mit einem Schmelzpunkt von weniger als 700°C beträgt vorzugsweise 5-40 Atomprozent, mehr bevorzugt 7 - 35 Atomprozent und besonders bevorzugt 10 - 35 Atomprozent, bezogen auf die Anzahl an Atomen in der Verbindungsschicht.

Gemäß einer bevorzugten Ausführungsform weist die Verbindungsschicht einen metallschichtnahen Bereich und einen keramikschichtnahen Bereich auf. Der metallschichtnahe Bereich ist vorzugsweise reicher an dem Metall mit einem Schmelzpunkt von wenigstens 700°C als der keramikschichtnahe Bereich. Der keramikschichtnahe Bereich ist vorzugsweise reicher an Aktivmetall als der metallschichtnahe Bereich. Gemäß einer besonders bevorzugten Ausführungsform ist der metallschichtnahe Bereich dicker als der keramikschichtnahe Bereich der Verbindungsschicht. Dabei kann es bevorzugt sein, dass das Verhältnis der Dicke des metallschichtnahen Bereichs der Verbindungsschicht zur Dicke des keramikschichtnahen Bereichs der Verbindungsschicht wenigstens 2 : 1, noch mehr bevorzugt wenigstens 3 : 1 und besonders bevorzugt wenigstens 5 : 1 beträgt.

Gemäß einer bevorzugten Ausführungsform liegt der maximale Gehalt an Silber vorzugsweise bei 15,0 Atomprozent, mehr bevorzugt bei 1,0 Atomprozent, noch mehr bevorzugt bei 0,5 Atomprozent und ganz besonders bevorzugt bei 0,1 Atomprozent, bezogen auf die Anzahl an Atomen in der Verbindungsschicht. Demnach kann es bevorzugt sein, dass die Verbindungsschicht silberfrei oder silberarm ist. Überraschenderweise hat sich gezeigt, dass ein Fehlen von Silber in der Verbindungsschicht oder ein nur geringer Gehalt von Silber in der Verbindungsschicht dazu führt, dass mit dem erfindungsgemäßen Verfahren in kürzerer Zeit ein zuverlässiger und vollständiger Abtrag des Aktivmetalls aus dem zu ätzenden Bereich der Verbindungsschicht erreicht werden kann. Ohne an eine Theorie gebunden sein zu wollen, könnte dieser Effekt darauf zu rückzuführen sein, dass die Gegenwart von Silber die Ausbildung eines metallschichtnahen Bereichs begünstigt, der durch Ätzen nur schwer zu entfernen ist. Die Bildung dieses silberhaltigen metallschichtnahen Bereichs könnte schließlich dazu führen, dass die Kontaktierung des aktivmetallhaltigen keramikschichtnahen Bereichs mit der Ätzlösung 2 wirksam blockiert wird. Diese Blockierung würde durch die Reduktion eines Anteils an Silber in der Verbindungsschicht vermindert oder sogar aufgehoben werden, so dass eine leichtere Entfernbarkeit des Aktivmetalls die Folge ist.

Gemäß einer bevorzugten Ausführungsform weisen das erste Metall-Keramik-Substrat und das zweite Metall-Keramik-Substrat jeweils auf
- eine zweite Metallschicht und
- eine zweite Verbindungsschicht, die sich zwischen der Keramikschicht und der zweiten Metallschicht befindet, wobei die zweite Verbindungsschicht (i) ein Metall mit einem Schmelzpunkt von wenigstens 700°C und (ii) ein Aktivmetall aufweist.

Derartige Metall-Keramik-Substrate werden auch doppelseitig metallisierte Metall-Keramik-Substrate genannt. Zu den Merkmalen der zweiten Metallschicht und der zweiten Verbindungsschicht kann auf die hierin beschriebenen Ausführungen zur Metallschicht und zur Verbindungsschicht Bezug genommen werden. Vorzugsweise sind demnach die zweite Metallschicht wie die hierin beschriebene Metallschicht und die zweite Verbindungsschicht wie die hierin beschriebene Verbindungsschicht ausgebildet.

Die Metall-Keramik-Substrate können durch ein herkömmliches und aus dem Stand der Technik bekanntes Verfahren hergestellt werden. Vorzugsweise werden die Metall-Keramik-Substrate mittels eines Lötverfahrens hergestellt. Gemäß einer bevorzugten Ausführungsform erfolgt die Herstellung der Metall-Keramik-Substrate durch ein AMB ("Active Metal Brazing") -Verfahren. Bei diesem Verfahren wird üblicherweise eine Metallfolie mit einem Keramikkörper unter Verwendung eines Lotmaterials verlötet, das Kupfer, Silber und ein Aktivmetall (zum Beispiel Titan) aufweist. Ein solches Verfahren ist zum Beispiel in der US 4591535 A offenbart. Gemäß einer weiteren bevorzugten Ausführungsform werden die Metall-Keramik-Substrate durch ein Verfahren hergestellt, bei dem eine Metallfolie mit einem Keramikkörper unter Verwendung eines Lotmaterials verlötet wird, das ein Metall mit einem Schmelzpunkt von wenigstens 700°C (zum Beispiel Kupfer), ein Metall mit einem Schmelzpunkt von weniger als 700°C (zum Beispiel Zinn) und ein Aktivmetall (zum Beispiel Titan) aufweist. Ein solches Verfahren ist zum Beispiel in der DE 102017114893 A1 offenbart.

In dem erfindungsgemäßen Verfahren wird eine Ätzlösung 1 bereitgestellt, die in der Lage ist, das Metall der Metallschicht und wenigstens teilweise das Metall mit einem Schmelzpunkt von wenigstens 700°C aus der Verbindungsschicht abzutragen. Bei der Ätzlösung 1 kann es sich zum Beispiel um eine aus dem Stand der Technik bekannte und für die Ätzung von Kupfer geeignete Ätzlösung handeln. Ätzlösung 1 kann daher zum Beispiel aus der Gruppe ausgewählt sein, die aus FeCl₃-Ätzlösungen und CuCl₂-Ätzlösungen besteht.

In dem erfindungsgemäßen Verfahren wird ferner eine Ätzlösung 2 bereitgestellt, die in der Lage ist, das Aktivmetall aus der Verbindungsschicht abzutragen. Bei der Ätzlösung 2 kann es sich um eine aus dem Stand der Technik bekannte Ätzlösung für Aktivmetalle handeln. Beispielhafte Ätzlösungen sind in der EP3688835 A1 und der EP3684148 A1 offenbart. Gemäß einer bevorzugten Ausführungsformen ist Ätzlösung 2 aus der Gruppe ausgewählt, die aus Ätzlösungen enthaltend Wasserstoffperoxid und aus Ätzlösungen enthaltend Ammoniumperoxodisulfat besteht. Zum Beispiel kann Ätzlösung 2 eine Ätzlösung sein, die Ammoniumfluorid und Fluorborsäure (zum Beispiel HBF₄) sowie Wasserstoffperoxid und/oder Ammoniumperoxodisulfat enthält.

Erfindungsgemäß erfolgt eine Maskierung von Bereichen auf dem ersten Metall-Keramik-Substrat und dem zweiten Metall-Keramik-Substrat, die nicht für das Abtragen vorgesehen sind. Die Maskierung ist nicht weiter eingeschränkt und kann auf eine dem Fachmann aus dem Stand der Technik bekannte Weise erfolgen. Für die Maskierung kann zum Beispiel ein Ätzresist verwendet werden. So ist es zum Beispiel möglich, einen Ätzresist auf die Metallschicht des Metall-Keramik-Substrats aufzubringen und zur Aushärtung nur die Bereiche zu belichten, die nicht für das Abtragen vorgesehen sind. Bei der anschließenden Kontaktierung mit den Ätzlösungen sind die maskierten Bereiche geschützt, so dass in diesen Bereichen kein Materialabtrag durch die Einwirkung der Ätzlösungen erfolgt. Dagegen sind die unmaskierten (nicht ausgehärteten) Bereiche im nachfolgenden Ätzschritt für die Ätzung zugänglich.

Gemäß der vorliegenden Erfindung erfolgt anschließend eine Kontaktierung des ersten Metall-Keramik-Substrats und des zweiten Metall-Keramik-Substrats mit der Ätzlösung 1.

In diesem Schritt wird in den unmaskierten Bereichen der Metall-Keramik-Substrate durch Einwirkung von Ätzlösung 1 das Metall aus der Metallschicht und wenigstens teilweise das Metall mit einem Schmelzpunkt von wenigstens 700°C aus der Verbindungsschicht entfernt. Ferner kann die Ätzlösung 1 auch so ausgestaltet sein, dass neben dem Metall der Metallschicht und dem Metall mit einem Schmelzpunkt von wenigstens 700°C auch weitere Metalle der Verbindungsschicht - soweit vorhanden - mit Ausnahme des Aktivmetalls entfernt werden. Die Art der Kontaktierung der Metall-Keramik-Substrate mit der Ätzlösung 1 ist nicht weiter eingeschränkt. Vorzugsweise kann es vorgesehen sein, dass die Metall-Keramik-Substrate in die Ätzlösung 1 eingetaucht oder mit dieser besprüht werden.

In dem erfindungsgemäßen Verfahren erfolgt im Anschluss eine Kontaktierung des ersten Metall-Keramik-Substrats und des zweiten Metall-Keramik-Substrats mit der Ätzlösung 2. In diesem Schritt wird in den unmaskierten Bereichen der Metall-Keramik-Substrate durch Einwirkung von Ätzlösung 2 das Aktivmetall entfernt. Dabei sind das erste Metall-Keramik-Substrat und das zweite Metall-Keramik-Substrat so angeordnet, dass eine Orthogonalprojektion des ersten Metall-Keramik-Substrats auf eine Projektionsebene parallel zur Metallschicht des ersten Metall-Keramik-Substrats die Metallschicht des zweiten Metall-Keramik-Substrats zu nicht mehr als 60% abschattet. Gemäß einer bevorzugten Ausführungsform erfolgt die Kontaktierung des ersten Metall-Keramik-Substrats und des zweiten Metall-Keramik-Substrats mit der Ätzlösung 2, wobei das erste Metall-Keramik-Substrat und das zweite Metall-Keramik-Substrat so angeordnet sind, dass eine Orthogonalprojektion des ersten Metall-Keramik-Substrats auf eine Projektionsebene parallel zur Metallschicht des ersten Metall-Keramik-Substrats die Metallschicht des zweiten Metall-Keramik-Substrats zu nicht mehr als 50%, besonders bevorzugt zu nicht mehr als 40%, ganz besonders bevorzugt zu nicht mehr als 30% und zum Beispiel zu nicht mehr als 15%, abschattet.

Die Orthogonalprojektion des ersten Metall-Keramik-Substrats erfolgt auf eine Projektionsebene, die parallel zur Metallschicht des ersten Metall-Keramik-Substrats verläuft. Vorzugsweise handelt es sich bei der Projektionsebene um eine Ebene, die von einer Abbildung aufgespannt wird, die durch Parallelverschiebung des ersten Metall-Keramik-Substrats erhalten wird. Dabei erfolgt vorzugsweise die Verschiebung in senkrechte Richtung zur Metallschicht des ersten Metall-Keramik-Substrats. Diese Parallelverschiebung kann in eine Richtung sowie in die Gegenrichtung erfolgen. Der Abstand zwischen der Metallschicht des ersten Metall-Keramik-Substrats und der hierzu parallelen Projektionsebene ist vorzugsweise so gewählt, dass der Abstand zwischen der Metallschicht des ersten Metall-Keramik-Substrats und der hierzu parallelen Projektionsebene größer oder gleich dem Abstand zwischen der Metallschicht des ersten Metall-Keramik-Substrats und einer Ebene ist, die durch das zweite Metall-Keramik-Substrat aufgespannt wird, wobei der Abstand zwischen der Metallschicht des ersten Metall-Keramik-Substrats und einer Ebene, die durch das zweite Metall-Keramik-Substrat aufgespannt wird, vorzugsweise entlang einer Senkrechten durch den Flächenschwerpunkt der Metallschicht des ersten Metall-Keramik-Substrats bestimmt wird. Der Abstand zwischen der Metallschicht des ersten Metall-Keramik-Substrats und der hierzu parallelen Projektionsebene ist daher vorzugsweise groß genug, um bei einer Orthogonalprojektion eine teilweise Abschattung des zweiten Metall-Keramik-Substrats, soweit dies aufgrund der Anordnung von erstem Metall-Keramik-Substrat und zweitem Metall-Keramik-Substrat überhaupt möglich ist, erreichen zu können. Zum Beispiel kann der Abstand zwischen der Metallschicht des ersten Metall-Keramik-Substrats und der hierzu parallelen Projektionsebene der größten Seitenlänge des ersten Metall-Keramik-Substrats entsprechen. Zum Beispiel kann der Abstand zwischen der Metallschicht des ersten Metall-Keramik-Substrats und der hierzu parallelen Projektionsebene 20 cm, 30 cm oder 50 cm betragen.

Sofern sich zwischen der Metallschicht des ersten Metall-Keramik-Substrats und der hierzu parallelen Projektionsebene das zweite Metall-Keramik-Substrat befindet, kann dessen Metallschicht durch die Orthogonalprojektion, gegebenenfalls teilweise, abgeschattet werden. Eine Abschattung liegt erfindungsgemäß unabhängig davon vor, ob die Metallschicht des ersten Metall-Keramik-Substrats der Metallschicht des zweiten Metall-Keramik-Substrats zugewandt oder abgewandt ist. Eine Abschattung der Metallschicht des zweiten Metall-Keramik-Substrat kann daher auch dann erreicht werden, wenn sich bei der Orthogonalprojektion zwischen der Metallschicht des ersten Metall-Keramik-Substrats und der Metallschicht des zweiten Metall-Keramik-Substrats noch die Keramikschicht des ersten Metall-Keramik-Substrats, die Keramikschicht des zweiten Metall-Keramik-Substrats, die Keramikschichten von erstem und zweitem Metall-Keramik-Substrat oder gegebenenfalls mit der Keramikschicht von erstem oder zweitem Metall-Keramik-Substrat verbundene Gegenstände (zum Beispiel eine weitere Metallschicht auf dem ersten und/oder zweiten Metall-Keramik-Substrat) befinden. Der Anteil an Abschattung ergibt sich vorzugsweise aus dem Verhältnis von (a) zu (b), wobei (a) die Fläche des durch die Orthogonalprojektion des ersten Metall-Keramik-Substrats auf eine Projektionsebene parallel zur Metallschicht des ersten Metall-Keramik-Substrats geschnittenen Bereichs auf dem zweiten Metall-Keramik-Substrats angibt und (b) die Fläche der Metallschicht des zweiten Metall-Keramik-Substrats angibt. Bei der Flächenberechnung ist eine etwaige Maskierung einer Metallschicht nicht zu berücksichtigen. Daher wird zur Flächenberechnung vorzugsweise die Fläche der Metallschicht herangezogen, die sich ohne Maskierung und Ätzung ergeben würde. Ebenso ist bei der Flächenberechnung eine etwaige weitere Metallschicht auf dem zweiten Metall-Keramik-Substrat, wie sie zum Beispiel bei einer doppelseitigen Metallisierung vorliegt, nicht zu berücksichtigen.

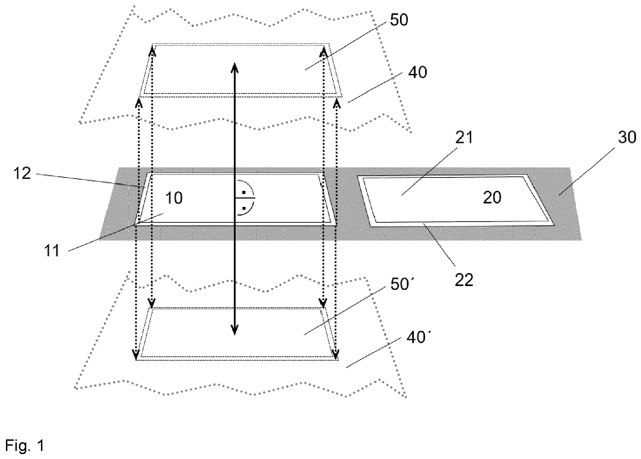

Fig. 1 zeigt eine Anordnung von einem ersten Metall-Keramik-Substrat 10 und einem zweiten Metall-Keramik-Substrat 20, wobei eine Orthogonalprojektion des ersten Metall-Keramik-Substrats 10 auf eine Projektionsebene 40, 40' parallel zur maskierten Metallschicht 11 des ersten Metall-Keramik-Substrats 10 die Metallschicht 21 des zweiten Metall-Keramik-Substrats 20 zu 0% abschattet. Gezeigt ist ein erstes Metall-Keramik-Substrat 10, das eine maskierte (nicht gezeigt) Metallschicht 11 aufweist, die mit einer Keramikschicht 12 verbunden ist. Die Keramikschicht 12 kann eine größere Abmessung aufweisen als die Metallschicht 11 und daher über die Metallschicht 11 hinausgehen. Ebenso gezeigt ist ein zweites Metall-Keramik-Substrat 20, das eine Metallschicht 21 aufweist, die mit einer Keramikschicht 22 verbunden ist. Das erste Metall-Keramik-Substrat 10 und das zweite Metall-Keramik-Substrat 20 liegen horizontal vollflächig auf einem Träger 30 auf. Eine Parallelverschiebung des ersten Metall-Keramik-Substrats 10 senkrecht zur Metallschicht 11 des ersten Metall-Keramik-Substrats 10 führt zu einer Abbildung 50, 50' des ersten Metall-Keramik-Substrats 10, die eine Projektionsebene 40, 40' aufspannt. Eine Orthogonalprojektion (mit unterbrochenen Pfeilen angedeutet) des ersten Metall-Keramik-Substrats 10 auf die Projektionsebene 40, 40' schneidet die Metallschicht 21 des zweiten Metall-Keramik-Substrats 20 nicht. Die Beschattung des zweiten Metall-Keramik-Substrats 20 durch eine Orthogonalprojektion des ersten Metall-Keramik-Substrats 10 auf eine Projektionsebene 40, 40' parallel zur Metallschicht 11 des ersten Metall-Keramik-Substrats 10 liegt daher bei 0%.

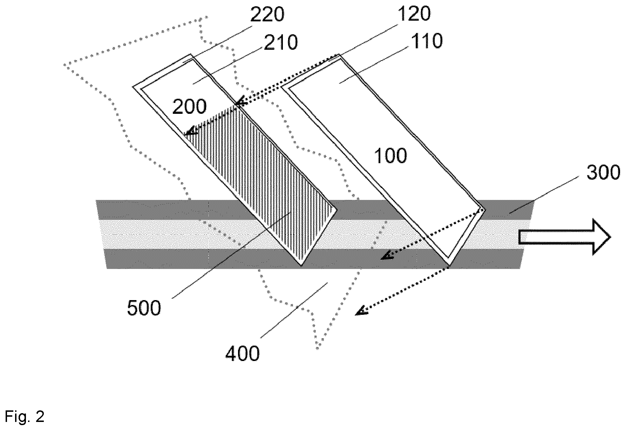

Fig. 2 zeigt eine Anordnung von einem ersten Metall-Keramik-Substrat 100 und einem zweiten Metall-Keramik-Substrat 200, wobei eine Orthogonalprojektion des ersten Metall-Keramik-Substrats 100 auf eine Projektionsebene 400 parallel zur maskierten Metallschicht 110 des ersten Metall-Keramik-Substrats 100 die Metallschicht 210 des zweiten Metall-Keramik-Substrats 200 zu mehr als 60% abschattet. Gezeigt ist ein erstes Metall-Keramik-Substrat 100 mit einer maskierten (nicht gezeigt) Metallschicht 110, die mit einer Keramikschicht 120 verbunden ist. Ebenfalls gezeigt ist ein zweites Metall-Keramik-Substrat 200 mit einer Metallschicht 210, die mit einer Keramikschicht 220 verbunden ist. Das erste Metall-Keramik-Substrat 100 und das zweite Metall-Keramik-Substrat 200 sind schräg auf einem Träger 300 (zum Beispiel einem Förderband) angeordnet. Die schräge Anordnung kann zum Beispiel mittels einer Auflage (nicht gezeigt) erreicht werden. Das zweite Metall-Keramik-Substrat 200 ist hinter dem ersten Metall-Keramik-Substrat 100 angeordnet und parallel zu diesem orientiert. Eine Projektionsebene 400 ist parallel von der maskierten Metallschicht 110 des ersten Metall-Keramik-Substrats 100 beabstandet. Sie kann hier zum Beispiel durch das zweite Metall-Keramik-Substrat 200 aufgespannt sein, da dieses parallel zu der maskierten Metallschicht 110 des ersten Metall-Keramik-Substrats 100 angeordnet ist. Die Position der Projektionsebene ist jedoch nicht weiter eingeschränkt. So kann die Projektionsebene alternativ auch parallel zur hier gezeigten Projektionsebene 400 verschoben sein. Sie kann insbesondere so gewählt sein, dass sie zur Metallfläche 110 des Metall-Keramik-Substrats 100 einen größeren Abstand als die Projektionsfläche 400 aufweist. Der Anteil an Abschattung des zweiten Metall-Keramik-Substrats 200 durch eine Orthogonalprojektion des ersten Metall-Keramik-Substrats 100 auf eine Projektionsebene parallel zur Metallschicht 110 des ersten Metall-Keramik-Substrats 110 ist insoweit unabhängig von der genauen Lage der Projektionsfläche. Eine Orthogonalprojektion (mit unterbrochenen Pfeilen angedeutet) des ersten Metall-Keramik-Substrats 100 auf die Projektionsebene 400 schneidet die Metallschicht 210 des zweiten Metall-Keramik-Substrats 200 in dem schraffierten Bereich 500. Die Beschattung des zweiten Metall-Keramik-Substrats 200 durch eine Orthogonalprojektion des ersten Metall-Keramik-Substrats 100 auf eine Projektionsebene 400 parallel zur Metallschicht 110 des ersten Metall-Keramik-Substrats 100 liegt bei über 60%.

Überraschenderweise wurde herausgefunden, dass die relative Position der einzelnen Metall-Keramik-Substrate zueinander einen erheblichen Einfluss auf die Wirksamkeit der Ätzung mit Ätzlösung 2 aufweist. Erfindungsgemäß vorteilhaft ist eine Anordnung der Metall-Keramik-Substrate, die es gewährleistet, dass die Oberflächen der Metall-Keramik-Substrate mit den unmaskierten (also zum Beispiel den von einer Ätzmaske nicht belegten) Bereichen möglichst frei für die Ätzlösung 2 zugänglich sind. Ohne an eine Theorie gebunden sein zu wollen, könnte dies darauf zurückzuführen sein, dass die unmaskierten Bereiche mit der Ätzlösung 2 so ideal beströmt werden können. Eine wirksame Beströmung mit Ätzlösung 2 könnte wiederum dazu führen, dass die Kontaktierung mit Ätzlösung 2 bereits innerhalb eines sehr kurzen Zeitraums eine vollständige Abtragung des Aktivmetalls von der Verbindungsschicht zur Folge hat.

Die Anordnung des ersten Metall-Keramik-Substrats und des zweiten Metall-Keramik-Substrat bei der Kontaktierung mit der Ätzlösung 2 ist nicht weiter eingeschränkt. Gemäß einer bevorzugten Ausführungsform werden das erste Metall-Keramik-Substrat und das zweite Metall-Keramik-Substrat mit der Ätzlösung 2 kontaktiert, während das erste Metall-Keramik-Substrat und das zweite Metall-Keramik-Substrat bewegt werden. Vorzugsweise handelt es sich bei der Bewegung um eine kontinuierliche Bewegung.

Gemäß einer bevorzugten Ausführungsform sind das erste Metall-Keramik-Substrat und das zweite Metall-Keramik-Substrat zur Kontaktierung mit Ätzlösung 2 auf einem Träger angeordnet. Besonders bevorzugt sind dabei das erste Metall-Keramik-Substrat und das zweite Metall-Keramik-Substrat auf demselben Träger angeordnet. Bei dem Träger kann es sich zum Beispiel um ein Förderband handeln. Gemäß einer bevorzugten Ausführungsform ist der Träger ein Förderband, das in eine Förderrichtung bewegt wird. Andererseits kann es sich bei dem Träger auch um eine Halterung für Metall-Keramik-Substrate handeln, die auf einem Förderband aufliegt. Das erste Metall-Keramik-Substrat und das zweite Metall-Keramik-Substrat können daher zum Beispiel unmittelbar auf dem Förderband als Träger angeordnet sein oder erste Metall-Keramik-Substrat und das zweite Metall-Keramik-Substrat können auf einem weiteren Träger (zum Beispiel einer Halterung) angeordnet sein, der wiederum auf dem Förderband als Träger angeordnet ist.

Die Anordnung des ersten Metall-Keramik-Substrats und des zweiten Metall-Keramik-Substrats auf einem Träger ist nicht weiter eingeschränkt. Gemäß einer bevorzugten Ausführungsform ist vorgesehen, dass das erste Metall-Keramik-Substrat und das zweite Metall-Keramik-Substrat auf einem der Träger vollflächig aufliegen. Alternativ kann vorgesehen sein, dass das erste Metall-Keramik-Substrat und das zweite Metall-Keramik-Substrat im Wesentlichen nur auf Führungsschienen eines Förderbandes aufliegen. Gemäß einer weiteren Alternative können das erste Metall-Keramik-Substrat und das zweite Metall-Keramik-Substrat auf Führungsschienen eines weiteren Trägers (zum Beispiel einer Halterung) aufliegen oder in einem Rahmen eines weiteren Trägers (zum Beispiel einer Halterung) eingespannt sein, und dieser Träger auf einem Förderband angeordnet sein.

Vorzugsweise liegen die Metall-Keramik-Substrate auf einem Träger so auf, dass die mit der Maskierung versehenen und vorzugsweise für die Behandlung mit der Ätzlösung 2 vorgesehenen Metallschichten des ersten Metall-Keramik-Substrats und des zweiten Metall-Keramik-Substrats von dem Träger wegweisen. Gemäß einer weiteren bevorzugten Ausführungsform handelt es sich beim ersten Metall-Keramik-Substrat und beim zweiten Metall-Keramik-Substrat jeweils um doppelseitig metallisierte Metall-Substrate, wobei besonders bevorzugt eine beidseitige Maskierung von Bereichen auf den Metallschichten des ersten Metall-Keramik-Substrats und von Bereichen auf den Metallschichten des zweiten Metall-Keramik-Substrats erfolgt. Bei dieser Ausführungsform kann eine Ausgestaltung vorteilhaft sein, bei der die Metall-Keramik-Substrate zur Behandlung mit Ätzlösung nur randseitig auf einem Träger, zum Beispiel auf Führungsschienen eines Förderbandes oder auf Führungsschienen einer Halterung, aufliegen oder in einem Rahmen einer Halterung eingespannt sind.

Die Möglichkeiten, das das erste Metall-Keramik-Substrat und das zweite Metall-Keramik-Substrat so anzuordnen, dass bei einer Kontaktierung mit der Ätzlösung 2 eine Orthogonalprojektion des ersten Metall-Keramik-Substrats auf eine Projektionsebene parallel zur Metallschicht des ersten Metall-Keramik-Substrats die Metallschicht des zweiten Metall-Keramik-Substrats zu nicht mehr als 60% abschattet, sind nicht weiter eingeschränkt.

Gemäß einer bevorzugten Ausführungsform sind bei der Kontaktierung mit der Ätzlösung 2 das erste Metall-Keramik-Substrat und das zweite Metall-Keramik-Substrat auf wenigstens eine der folgenden Weisen auf einem Träger, vorzugsweise auf demselben Träger, wobei der Träger vorzugsweise ein Förderband ist, das besonders bevorzugt in eine Förderrichtung bewegt wird, angeordnet:
a) das erste Metall-Keramik-Substrat und das zweite Metall-Keramik-Substrat sind nicht gestapelt angeordnet;
b) das erste Metall-Keramik-Substrat und das zweite Metall-Keramik-Substrat sind in einer im Wesentlichen horizontalen Position angeordnet;
c) das erste Metall-Keramik-Substrat und das zweite Metall-Keramik-Substrat sind in einer im Wesentlichen vertikalen Position und in Bezug auf die Förderrichtung hintereinander angeordnet;
d) das erste Metall-Keramik-Substrat und das zweite Metall-Keramik-Substrat sind so angeordnet, dass das erste Metall-Keramik-Substrat und die Förderrichtung einen Winkel beschreiben, der nicht mehr als 45°, mehr bevorzugt nicht mehr als 30° und noch mehr bevorzugt nicht mehr als 20° beträgt, und das zweite Metall-Keramik-Substrat und die Förderrichtung einen Winkel beschreiben, der nicht mehr als 45°, mehr bevorzugt nicht mehr als 30° und noch mehr bevorzugt nicht mehr als 20° beträgt.

Demnach können das erste Metall-Keramik-Substrat und das zweite Metall-Keramik-Substrat bei der Kontaktierung mit Ätzlösung 2 gemäß einer Ausführungsform nicht gestapelt angeordnet sein. In diesem Fall sind das erste Metall-Keramik-Substrat und das zweite Metall-Keramik-Substrat vorzugsweise nebeneinander angeordnet. Vorzugsweise sind das erste Metall-Keramik-Substrat und das zweite Metall-Keramik-Substrat dabei parallel zueinander angeordnet.

Gemäß einer weiteren bevorzugten Ausführungsform sind das erste Metall-Keramik-Substrat und das zweite Metall-Keramik-Substrat in einer im Wesentlichen horizontalen Position angeordnet. In diesem Fall sind das erste Metall-Keramik-Substrat und das zweite Metall-Keramik-Substrat vorzugsweise nebeneinander angeordnet. Vorzugsweise sind das erste Metall-Keramik-Substrat und das zweite Metall-Keramik-Substrat dabei parallel zueinander angeordnet. Zum Beispiel können in diesem Fall das erste Metall-Keramik-Substrat und das zweite Metall-Keramik-Substrat auf jeweils einer ihrer Metallschichten liegend, besonders bevorzugt auf jeweils der unmaskierten Metallschicht liegend, angeordnet sein.

Gemäß einer weiteren bevorzugten Ausführungsform sind das erste Metall-Keramik-Substrat und das zweite Metall-Keramik-Substrat in einer im Wesentlichen vertikalen Position und in Bezug auf die Förderrichtung hintereinander angeordnet. In diesem Fall können das erste Metall-Keramik-Substrat und das zweite Metall-Keramik-Substrat zum Beispiel in einer Halterung auf dem Förderband angeordnet sein. Dabei können das erste Metall-Keramik-Substrat und das zweite Metall-Keramik-Substrat in derselben Halterung angeordnet sein oder das erste Metall-Keramik-Substrat und das zweite Metall-Keramik-Substrat können in unterschiedlichen Halterungen angeordnet sein. Dabei sind das erste Metall-Keramik-Substrat und das zweite Metall-Keramik-Substrat in Bezug auf die Förderrichtung hintereinander angeordnet, so dass eine ideale Beströmung mit der Ätzlösung 2 erfolgen kann.

Gemäß einer weiteren bevorzugten Ausführungsform sind das erste Metall-Keramik-Substrat und das zweite Metall-Keramik-Substrat so angeordnet, dass das erste Metall-Keramik-Substrat und die Förderrichtung einen Winkel beschreiben, der nicht mehr als 45°, mehr bevorzugt nicht mehr als 30° und noch mehr bevorzugt nicht mehr als 20° beträgt, und das zweite Metall-Keramik-Substrat und die Förderrichtung einen Winkel beschreiben, der nicht mehr als 45°, mehr bevorzugt nicht mehr als 30° und noch mehr bevorzugt nicht mehr als 20° beträgt. Gemäß noch einer weiteren bevorzugten Ausführungsform sind das erste Metall-Keramik-Substrat und das zweite Metall-Keramik-Substrat so angeordnet, dass das erste Metall-Keramik-Substrat und die Förderrichtung einen Winkel beschreiben, der wenigstens 1°, mehr bevorzugt wenigstens 3° und besonders bevorzugt wenigstens 5° beträgt, und das zweite Metall-Keramik-Substrat und die Förderrichtung einen Winkel beschreiben, der wenigstens 1°, mehr bevorzugt wenigstens 3° und besonders bevorzugt wenigstens 5° beträgt. Ein solcher Winkel zwischen dem ersten beziehungsweise zweiten Metall-Keramik-Substrat und der Förderrichtung des Förderbandes kann günstig sein, um das Ablaufen der Ätzlösung 2 zu vereinfachen. Gemäß noch einer weiteren bevorzugten Ausführungsform sind das erste Metall-Keramik-Substrat und das zweite Metall-Keramik-Substrat so angeordnet, dass das erste Metall-Keramik-Substrat und die Förderrichtung einen Winkel im Bereich von 1 - 45°, mehr bevorzugt einen Winkel im Bereich von 3 - 30° und besonders bevorzugt einen Winkel im Bereich von 5-20° beschreiben, und das zweite Metall-Keramik-Substrat und die Förderrichtung einen Winkel im Bereich von 1 - 45°, mehr bevorzugt einen Winkel im Bereich von 3 - 30° und besonders bevorzugt einen Winkel im Bereich von 5 - 20° beschreiben.

Gemäß einer weiteren bevorzugten Ausführungsform wird das erfindungsgemäße Verfahren kontinuierlich betrieben.

Die Art der Kontaktierung des ersten Metall-Keramik-Substrats und des zweiten Metall-Keramik-Substrats mit der Ätzlösung 2 ist nicht weiter eingeschränkt. Gemäß einer bevorzugten Ausführungsform erfolgt die Kontaktierung des ersten Metall-Keramik-Substrats und des zweiten Metall-Keramik-Substrats mit der Ätzlösung 2, indem das erste Metall-Keramik-Substrat und das zweite Metall-Keramik-Substrat mit der Ätzlösung 2 besprüht werden, indem das erste Metall-Keramik-Substrat und das zweite Metall-Keramik-Substrat in Ätzlösung 2 eingetaucht werden oder indem das erste Metall-Keramik-Substrat und das zweite Metall-Keramik-Substrat durch die Ätzlösung 2 hindurchgeführt werden.

Gemäß noch einer weiteren bevorzugten Ausführungsform werden das erste Metall-Keramik-Substrat und das zweite Metall-Keramik-Substrat bei der Kontaktierung mit der Ätzlösung 2 mit Ultraschall kontaktiert.

Gemäß einer bevorzugten Ausführungsform wird die Maskierung vom ersten Metall-Keramik-Substrat und vom zweiten Metall-Keramik-Substrat entfernt. Zum Beispiel kann die Maskierung vom ersten Metall-Keramik-Substrat und vom zweiten Metall-Keramik-Substrat nach der Kontaktierung mit Ätzlösung 2 entfernt werden. Andererseits ist es auch möglich, die Maskierung vom ersten Metall-Keramik-Substrat und vom zweiten Metall-Keramik-Substrat bereits nach der Kontaktierung mit Ätzlösung 1 zu entfernen. Die Entfernung der Maskierung ist nicht weiter eingeschränkt und kann auf eine dem Fachmann bekannte Weise erfolgen.

Ferner kann es vorteilhaft sein, wenn vor, zwischen und/oder nach einzelnen Schritten des erfindungsgemäßen Verfahrens Waschungen erfolgen. Die Waschungen erfolgen vorzugsweise mit Wasser. Besonders bevorzugt werden das erste Metall-Keramik-Substrat und das zweite Metall-Keramik-Substrat gewaschen
- vor der Maskierung,
- vor der Behandlung mit Ätzlösung 1,
- vor der Behandlung mit Ätzlösung 2,
- vor der Entfernung der Maskierung und/oder
- nach der Entfernung der Maskierung.

Nach den Waschungen werden das erste Metall-Keramik-Substrat und das zweite Metall-Keramik-Substrat vorzugsweise getrocknet.

Ein Metall-Keramik-Substrat, das durch das vorstehend beschriebene Verfahren erhalten wird, weist besonders feine Strukturierungen auf und ist für die Verwendung in der Leistungselektronik hervorragend geeignet.

### Ausführungsbeispiele:

### Beispiel zur Herstellung von Metall-Keramik-Substraten:

Für die Herstellung von Metall-Keramik-Substraten wurden zunächst 19,8 Gewichtsprozent Zinnpulver (7 - 11 µm), 3,7 Gewichtsprozent Titanhydrid und 6,5 Gewichtsprozent eines organischen Vehikels bei 1930 Umdrehungen pro Minute für 30 Minuten in einem Standmischgerät gemischt. Danach wurden 3,0 Gewichtsprozent Texanol und 67 Gewichtsprozent Kupferpulver (7 - 11 µm) in Inkrementen zugegeben. Die erhaltene Mischung wurde bei hoher Geschwindigkeit solange gerührt, bis eine homogene Paste erhalten wurde.

Mit der so erhaltenen Paste wurden Keramikkörper an ihren gegenüberliegenden Oberflächen beidseitig mit Metallfolien verbunden. Hierzu wurden Keramikkörper mit den Abmessungen 174 x 139 x 0,32 mm (erhalten von Toshiba Materials) verwendet, die eine identische Vorder- und Rückseitenbeschaffung aufwiesen. Die Paste wurde mittels eines 280 Mesh-Siebs auf einen Bereich der Abmessung 168 x 130 mm auf die Rückseite der Keramikkörper siebgedruckt und für 15 Minuten bei 125°C vorgetrocknet. Die Pastendicke nach der Vortrocknung betrug 25 +/- 5 µm. Anschließend wurde eine Kupferfolie aus sauerstofffreiem, hochleitfähigem Kupfer mit einer Reinheit von 99,99% und einer Abmessung von 170 x 132 x 0.3 mm auf die vorgetrocknete Paste gelegt. Danach wurde die so erzeugte Anordnung herumgedreht, die Paste gleichermaßen auf die Vorderseite des Keramikkörpers gedruckt, vorgetrocknet und mit einer Kupferfolie bestückt, um eine Sandwichanordnung zu erhalten. Sodann wurde die Sandwichanordnung mit einer Siliziumcarbidplatte mit einem Gewicht von 1 kg beschwert, bei einer Höchsttemperatur von 910°C (gemessen mit einem Thermocouple) für 20 Minuten gebrannt und anschließend auf Raumtemperatur abgekühlt, um ein Metall-Keramik-Substrat zu erhalten, das eine Keramikschicht enthielt, die beidseitig mit einer Kupferschicht über eine Verbindungsschicht verbunden war.

### Beispiele zur Ätzung der Metall-Keramik-Substrate:

Die gemäß dem vorstehenden Herstellungsbeispiel erhaltenen Metall-Keramik-Substrate wurden auf der Oberseite mit einer Ätzmaske mit maskierten und unmaskierten Bereichen versehen. Nach einer Waschung mit Wasser wurden die Metall-Keramik-Substrate mit einer Ätzlösung 1 zur Entfernung von Kupfer aus der Kupferschicht und von Kupfer und Zinn aus der Verbindungsschicht behandelt. Anschließend wurden die Metall-Keramik-Substrate gewaschen und gemäß den nachstehenden Beispielen und Vergleichsbeispielen mit Ätzlösung 2 zur Entfernung von Titan aus der Verbindungsschicht behandelt.

### Beispiel 1:

Die Metall-Keramik-Substrate wurden in horizontaler Position auf ein Förderband gelegt und mit dem Förderband durch ein Bad mit Ätzlösung 2 befördert.

### Beispiel 2:

Die Metall-Keramik-Substrate wurden in horizontaler Position auf ein Förderband gelegt und mit dem Förderband durch ein Bad mit Ätzlösung 2 befördert und dabei mit Ultraschall behandelt.

### Beispiel 3:

Die Metall-Keramik-Substrate wurden in horizontaler Position auf ein Förderband gelegt und unter Sprühdüsen hindurchbefördert, aus denen heraus die Metall-Keramik-Substrate mit Ätzlösung 2 besprüht wurden.

### Beispiel 4:

Die Metall-Keramik-Substrate wurden in horizontaler Position auf ein Förderband gelegt und in stationärem Zustand mit einer Ätzlösung 2 besprüht.

### Beispiel 5:

Die Metall-Keramik-Substrate wurden auf ein Förderband gelegt und mit dem Förderband durch ein Bad mit Ätzlösung 2 befördert und dabei mit Ultraschall behandelt. Dabei beschrieben die Metall-Keramik-Substrate und die Förderrichtung des Förderbandes jeweils einen Winkel von 15°. Die schräge Positionierung der Metall-Keramik-Substrate wurde durch eine Auflage erreicht. Die Metall-Keramik-Substrate waren so angeordnet, dass eine Orthogonalprojektion eines Metall-Keramik-Substrats auf eine Projektionsebene parallel zur maskierten Metallschicht dieses Metall-Keramik-Substrat die Metallschicht eines anderen (benachbarten) Metall-Keramik-Substrats zu höchstens 15% abschattete.

### Beispiel 6:

Die Metall-Keramik-Substrate wurden auf ein Förderband gelegt und mit dem Förderband durch ein Bad mit Ätzlösung 2 befördert und dabei mit Ultraschall behandelt. Dabei beschrieben die Metall-Keramik-Substrate und die Förderrichtung des Förderbandes jeweils einen Winkel von 10°. Die schräge Positionierung der Metall-Keramik-Substrate wurde durch eine Auflage erreicht. Die Metall-Keramik-Substrate waren so angeordnet, dass eine Orthogonalprojektion eines Metall-Keramik-Substrats auf eine Projektionsebene parallel zur maskierten Metallschicht dieses Metall-Keramik-Substrat die Metallschicht eines anderen (benachbarten) Metall-Keramik-Substrats zu höchstens 50% abschattete.

### Vergleichsbeispiel 1:

Die Metall-Keramik-Substrate wurden in vertikaler Position in einer Halterung auf ein Förderband gelegt und mit dem Förderband durch ein Bad mit Ätzlösung 2 befördert.

### Vergleichsbeispiel 2:

Die Metall-Keramik-Substrate wurden in vertikaler Position in einer Halterung auf ein Förderband gelegt und mit dem Förderband durch ein Bad mit Ätzlösung 2 befördert und dabei mit Ultraschall behandelt.

### Vergleichsbeispiel 3:

Die Metall-Keramik-Substrate wurden in vertikaler Position in einer Halterung auf ein Förderband gelegt und unter Sprühdüsen hindurchbefördert, aus denen heraus die Metall-Keramik-Substrate mit Ätzlösung 2 besprüht wurden.

### Vergleichsbeispiel 4:

Die Metall-Keramik-Substrate wurden in vertikaler Position in einer Halterung auf ein Förderband gelegt und in stationärem Zustand mit einer Ätzlösung 2 besprüht.

### Vergleichsbeispiel 5:

Die Metall-Keramik-Substrate wurden auf ein Förderband gelegt und mit dem Förderband durch ein Bad mit Ätzlösung 2 befördert und dabei mit Ultraschall behandelt. Dabei beschrieben die Metall-Keramik-Substrate und die Förderrichtung des Förderbandes jeweils einen Winkel von 10°. Die schräge Positionierung der Metall-Keramik-Substrate wurde durch eine Auflage erreicht. Die Metall-Keramik-Substrate waren so angeordnet, dass eine Orthogonalprojektion eines Metall-Keramik-Substrats auf eine Projektionsebene parallel zur maskierten Metallschicht dieses Metall-Keramik-Substrats die Metallschicht eines anderen (benachbarten) Metall-Keramik-Substrats zu 70% abschattete.

### Auswertung:

Die einzelnen Beispiele und Vergleichsbeispiele wurden mit unterschiedlichen Arten von Metall-Keramik-Substraten, mit unterschiedlichen Arten von Ätzlösung 2 und bei unterschiedlichen Geschwindigkeiten des Förderbandes wiederholt. Für die jeweiligen Beispiele und Vergleichsbeispiele wurden jeweils dieselben der vorgenannten Parameter verwendet. Die Menge an verbleibendem Titan in der Verbindungsschicht der Metall-Keramik-Substrate wurde qualitativ bestimmt. Die Ergebnisse sind in Tabelle 1 angegeben:

**Tabelle 1:**

| Beispiel | Abschattung | Menge an verbleibendem Titan |
|---|---|---|
| Beispiel 1 | 0% | ++ |
| Beispiel 2 | 0% | +++ |
| Beispiel 3 | 0% | ++ |
| Beispiel 4 | 0% | ++ |
| Beispiel 5 | 15% | +++ |
| Beispiel 6 | 50% | ++ |
| Vergleichsbeispiel 1 | ∼100% | - |
| Vergleichsbeispiel 2 | ∼100% | ○ |
| Vergleichsbeispiel 3 | ∼100% | -- |
| Vergleichsbeispiel 4 | ∼100% | -- |
| Vergleichsbeispiel 5 | 70% | ○ |

Es bedeuten:
- +++:: sehr geringer restlicher Titangehalt
- ---:: sehr hoher restlicher Titangehalt
- ○:: gut detektierbarer restlicher Titangehalt

Die Ergebnisse zeigen, dass ein besonderes wirksamer Abtrag des Aktivmetalls erreicht werden kann, wenn bei der Kontaktierung mit Ätzlösung 2 die Metall-Keramik-Substrate so angeordnet sind, dass eine Orthogonalprojektion eines Metall-Keramik-Substrats auf eine Projektionsebene parallel zur Metallschicht dieses Metall-Keramik-Substrats die Metallschicht eines weiteren Metall-Keramik-Substrats zu nicht mehr als 60% abschattet, so wie dies zum Beispiel bei einer horizontalen oder nahezu horizontalen Position der Metall-Keramik-Substrate, in der diese vereinzelt sind, der Fall ist. Ebenso zeigen die Ergebnisse, dass in einem nach dem erfindungsgemäßen Verfahren erhaltenen Metall-Keramik-Substrat das freie Aktivmetall praktisch vollständig abgetragen ist.

## Patentansprüche

1. Verfahren zur Strukturierung von Metall-Keramik-Substraten umfassend die Schritte:
a) Bereitstellung eines ersten Metall-Keramik-Substrats und eines zweiten Metall-Keramik-Substrats, jeweils aufweisend
- eine Keramikschicht,
- eine Metallschicht und
- eine Verbindungsschicht, die sich zwischen der Keramikschicht und der Metallschicht befindet, wobei die Verbindungsschicht (i) ein Metall mit einem Schmelzpunkt von wenigstens 700°C und (ii) ein Aktivmetall aufweist,
b) Bereitstellung einer Ätzlösung 1, die in der Lage ist, das Metall aus der Metallschicht und wenigstens teilweise das Metall mit einem Schmelzpunkt von wenigstens 700°C aus der Verbindungsschicht abzutragen,
c) Bereitstellung einer Ätzlösung 2, die in der Lage ist, das Aktivmetall aus der Verbindungsschicht abzutragen,
d) Maskierung von Bereichen auf der Metallschicht des ersten Metall-Keramik-Substrats und auf der Metallschicht des zweiten Metall-Keramik-Substrats, die nicht für das Abtragen vorgesehen sind,
e) Kontaktierung des ersten Metall-Keramik-Substrats und des zweiten Metall-Keramik-Substrats mit der Ätzlösung 1 und
f) Kontaktierung des ersten Metall-Keramik-Substrats und des zweiten Metall-Keramik-Substrats mit der Ätzlösung 2, wobei das erste Metall-Keramik-Substrat und das zweite Metall-Keramik-Substrat so angeordnet sind, dass eine Orthogonalprojektion des ersten Metall-Keramik-Substrats auf eine Projektionsebene parallel zur Metallschicht des ersten Metall-Keramik-Substrats die Metallschicht des zweiten Metall-Keramik-Substrats zu nicht mehr als 60% abschattet.

2. Verfahren nach Anspruch 1, **dadurch gekennzeichnet, dass** die Keramik der Keramikschicht aus der Gruppe ausgewählt ist, die aus Aluminiumnitridkeramiken, Siliziumnitridkeramiken und Aluminiumoxidkeramiken besteht.

3. Verfahren nach Anspruch 1 oder 2, **dadurch gekennzeichnet, dass** das Metall der Metallschicht Kupfer ist.

4. Verfahren nach einem der vorangegangenen Ansprüche, **dadurch gekennzeichnet, dass** das Metall mit einem Schmelzpunkt von wenigstens 700°C Kupfer ist.

5. Verfahren nach einem der vorangegangenen Ansprüche, **dadurch gekennzeichnet, dass** die Verbindungsschicht ein Metall mit einem Schmelzpunkt von weniger als 700°C aufweist.

6. Verfahren nach Anspruch 5, **dadurch gekennzeichnet, dass** das Metall mit einem Schmelzpunkt von weniger als 700°C aus der Gruppe ausgewählt ist, die aus Zinn, Bismut, Indium, Gallium, Zink, Antimon und Magnesium besteht.

7. Verfahren nach einem der vorangegangenen Ansprüche, **dadurch gekennzeichnet, dass** das Aktivmetall aus der Gruppe ausgewählt ist, die aus Titan, Zirkonium, Niob, Tantal, Vanadium und Hafnium besteht.

8. Verfahren nach einem der vorangegangenen Ansprüche, **dadurch gekennzeichnet, dass** der maximale Gehalt an Silber bei 10,0 Atomprozent und mehr bevorzugt bei 1,0 Atomprozent, bezogen auf die Anzahl an Atomen in der Verbindungsschicht, liegt.

9. Verfahren nach einem der vorangegangenen Ansprüche, **dadurch gekennzeichnet, dass** bei der Kontaktierung des ersten Metall-Keramik-Substrats und des zweiten Metall-Keramik-Substrats mit der Ätzlösung 2 das erste Metall-Keramik-Substrat und das zweite Metall-Keramik-Substrat so angeordnet sind, dass eine Orthogonalprojektion des ersten Metall-Keramik-Substrats auf eine Projektionsebene parallel zur Metallschicht des ersten Metall-Keramik-Substrats die Metallschicht des zweiten Metall-Keramik-Substrats zu nicht mehr als 50%, vorzugsweise zu nicht mehr als 40%, besonders bevorzugt zu nicht mehr als 30% und ganz besonders bevorzugt zu nicht mehr als 15%, abschattet.

10. Verfahren nach einem der vorangegangenen Ansprüche, **dadurch gekennzeichnet, dass** bei der Kontaktierung mit Ätzlösung 2 das erste Metall-Keramik-Substrat und das zweite Metall-Keramik-Substrat auf einem Träger, vorzugsweise auf demselben Träger, angeordnet sind.

11. Verfahren nach Anspruch 10, **dadurch gekennzeichnet, dass** der Träger ein Förderband ist, das in eine Förderrichtung bewegt wird.

12. Verfahren nach Anspruch 11, **dadurch gekennzeichnet, dass** bei der Kontaktierung mit der Ätzlösung 2 das erste Metall-Keramik-Substrat und das zweite Metall-Keramik-Substrat auf wenigstens eine der folgenden Weisen angeordnet sind:
a) das erste Metall-Keramik-Substrat und das zweite Metall-Keramik-Substrat sind nicht gestapelt angeordnet;
b) das erste Metall-Keramik-Substrat und das zweite Metall-Keramik-Substrat sind in einer im Wesentlichen horizontalen Position angeordnet;
c) das erste Metall-Keramik-Substrat und das zweite Metall-Keramik-Substrat sind in einer im Wesentlichen vertikalen Position und in Bezug auf die Förderrichtung hintereinander angeordnet;
d) das erste Metall-Keramik-Substrat und das zweite Metall-Keramik-Substrat sind so angeordnet, dass das erste Metall-Keramik-Substrat und die Förderrichtung einen Winkel beschreiben, der nicht mehr als 45°, mehr bevorzugt nicht mehr als 30° und noch mehr bevorzugt nicht mehr als 20° beträgt, und das zweite Metall-Keramik-Substrat und die Förderrichtung einen Winkel beschreiben, der nicht mehr als 45°, mehr bevorzugt nicht mehr als 30° und noch mehr bevorzugt nicht mehr als 20° beträgt.

13. Strukturiertes Metall-Keramik-Substrat erhältlich nach einem der Ansprüche 1 - 12.
